# EUROPEAN PATENT SPECIFICATION

(11) **EP 3 351 922 B1**
(45) Date of publication and mention of the grant of the patent: **11.08.2021**
(21) Application number: 16892669.9
(22) Date of filing: 25.10.2016
(51) Int. Cl.: G01N 1/28, G01N 1/32, H01L 21/66

(54) **METHOD FOR ANALYSIS OF A SUBSTRATE USING A NOZZLE**
VERFAHREN ZUR ANALYSE EINES SUBSTRATS UNTER VERWENDUNG EINER DÜSE
PROCÉDÉ D'ANALYSE D'UN SUBSTRAT AU MOYEN D'UNE BUSE

(30) Priority: 01.03.2016 JP 2016038639; 18.10.2016 JP 2016204062
(43) Date of publication of application: 25.07.2018
(73) Proprietor: Ias Inc., Kunitachi-shi, Tokyo 186-0003 (JP)
(72) Inventor: KAWABATA, Katsuhiko, Kunitachi-shi Tokyo 186-0003 (JP); LEE, Sungjae, Kunitachi-shi Tokyo 186-0003 (JP); ICHINOSE, Tatsuya, Kunitachi-shi Tokyo 186-0003 (JP)
(74) Representative: Weickmann & Weickmann PartmbB
(86) International application number: PCT/JP2016/081508
(87) International publication number: WO 2017/149833

(56) References cited:
- JP-A- H0 845 832
- JP-A- H1 133 506
- JP-A- H05 256 749
- JP-A- H11 190 730
- JP-A- 2011 128 033
- JP-A- 2011 128 033
- JP-A- 2011 232 182
- JP-A- 2012 009 475
- JP-A- 2013 257 272
- JP-A- 2015 099 103
- US-A1- 2004 261 817
- US-A1- 2008 078 421
- US-A1- 2014 307 238

## Description

### Technical Field

The present invention relates to a method for analysis of a substrate using a nozzle for analyzing an analysis object such as a very small amount of metal which is contained in a substrate.

### Background Art

A nozzle to be used for analysis of a substrate such as a semiconductor wafer is used when a metal, an organic substance or the like mixed in a substrate in a production process or the like is detected with a very small amount of an analysis liquid. Specifically, in analysis of a substrate with a silicon oxide film or nitride film or the like formed on a base material such as a silicon wafer, the nozzle is used when etching as a pretreatment of the formed film by a vapor phase decomposition method or the like is performed to leave impurities in the formed film as residues on a substrate surface, a very small amount of an analysis liquid is then discharged, and the substrate surface is scanned with the discharged analysis liquid to recover the impurities. On a hydrophobic substrate, an analysis liquid is easily kept in a droplet state by surface tension, and therefore a substrate surface can be scanned as described above. A metal etc. on the substrate can be moved into the analysis liquid by such scanning with the use of the nozzle, followed by analyzing the analysis liquid.

As the nozzle for analysis of a substrate, a nozzle is known which is configured to discharge an analysis liquid onto a substrate from a tip and suction the analysis liquid after scanning a substrate surface with the discharged analysis liquid and which includes a double pipe including a nozzle main body that discharges and suctions the analysis liquid, and an outer pipe disposed on the outer periphery of the nozzle main body so as to surround the scanning analysis liquid (e.g. Patent Document 1). The nozzle for analysis of a substrate with a double pipe structure, which is disclosed in Patent Document 1, has such a characteristic that a substrate surface can be scanned in a short time, and an analysis liquid hardly falls during scanning.

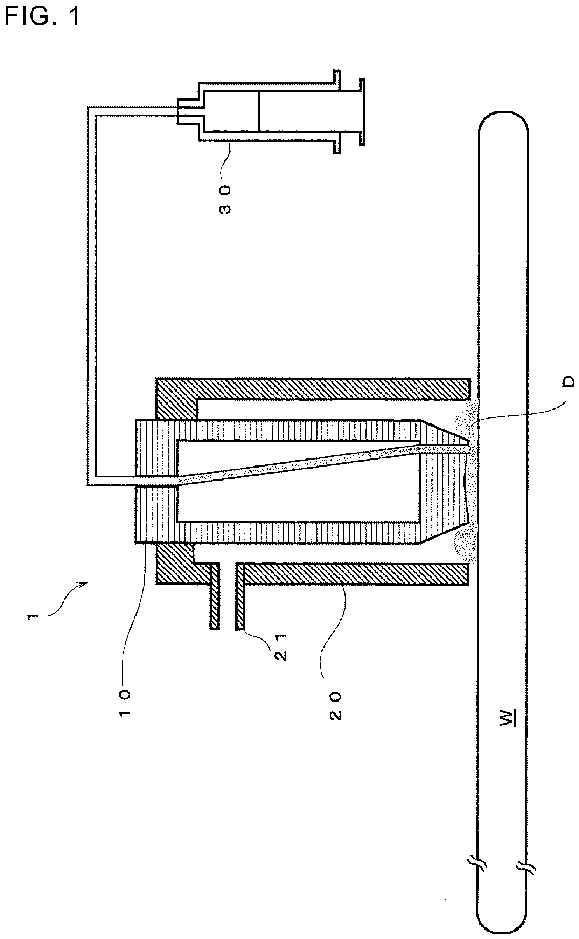

Specifically, the nozzle for analysis of a substrate with a double pipe structure is one shown in Fig. 1. A nozzle 1 in Fig. 1 includes a double pipe including a nozzle main body 10 and an outer pipe 20, and the nozzle main body 10 is connected to a syringe pump 30 via a tube, so that an analysis liquid D can be discharged. The outer pipe 20 is provided with a suction means 21 connected to a pump (not illustrated) so that a space between the nozzle main body 10 and the outer pipe 20 is brought into a reduced-pressure atmosphere. The nozzle for analysis of a substrate as shown in Fig. 1 is moved in such a manner that a surface of a substrate to be analyzed is scanned with the analysis liquid D held at a tip portion of the nozzle main body 10. During scanning, a space between the nozzle main body 10 and the outer pipe 20 is brought into a pressure-reduced atmosphere to prevent falling of the analysis liquid held at the tip portion of the nozzle main body 10. Thus even when the nozzle diameter is increased for improving the efficiency of substrate analysis, the analysis liquid does not fall.

In addition, as another prior art, there has been proposed a substrate treatment apparatus for treating a surface of a substrate with droplets, the substrate treatment apparatus including: a tool capable of expelling a gas from an opening provided along a circular imaginary line; a pressure sensor for detecting an internal pressure of the gas expelled from the opening in the tool; and a scanning device which is capable of adjusting a position of the tool along a direction orthogonal to the surface of the substrate so as to reduce a difference between the internal pressure and a specific pressure value as a predetermined pressure value while the gas expelled from the opening is sprayed to the surface of the substrate with the tool held in such a manner that droplets deposited on the substrate surface are surrounded by the opening when the substrate is viewed in the direction orthogonal to the surface of the substrate, and which is capable of relatively moving the tool along the surface of the substrate while the gas expelled from the opening is sprayed to the surface of the substrate with the tool held in such a manner that droplets deposited on the substrate surface are surrounded by the opening when the substrate is viewed in the direction orthogonal to the surface of the substrate (e.g. Patent Document 2).

In the substrate treatment apparatus in Patent Document 2, droplets can be prevented from falling from the tool by spraying a gas from the periphery of the droplets (of, for example, an analysis liquid) deposited on the surface of the substrate. The substrate treatment apparatus is capable of holding droplets even when the surface of the substrate is hydrophilic to the droplets.

In Patent Document 3 a foreign matter removing apparatus for removing foreign matter from a surface of a substrate is disclosed. The apparatus is provided with a substrate rotating mechanism which holds and rotates the substrate, and a fluid mixture supplying mechanism which generates a fluid mixture by mixing a treatment liquid and a gas, and supplies the fluid mixture onto the surface of the substrate held by the substrate rotating mechanism. The treatment liquid may be deionized water or a resist removing liquid. Examples of the foreign matter to be removed include a resist film formed on the substrate and a residue remaining on the surface of the substrate after ashing of the resist film.

### Related Art Document

### Patent Documents

Patent Document 1: JP 2011-128033 A
Patent Document 2: JP 2012-009475 A
Patent Document 3 : US 2004/0261817 A1

However, even in the case of the nozzle in Patent Document 1, a phenomenon in which an analysis liquid is leaked on a side opposite to the moving direction (scanning direction) of a nozzle tends to easily occur in analysis of a substrate surface with a nozzle tip portion relatively moved (scanned) with respect to the substrate surface when the substrate surface has high hydrophilicity. Specifically, in analysis of a substrate surface having high hydrophilicity, a phenomenon easily occurs in which the analysis liquid D is leaked on a side opposite to the scanning direction from the tip of the nozzle.

In addition, in the substrate treatment apparatus in Patent Document 2, droplets can be reliably held, but when the pressure of a gas expelled from the opening is excessively high, the contact area of the held droplets with the substrate decreases, and therefore it is necessary to strictly adjust the pressure. Consequently, the apparatus structure tends to be complicated. In addition, strict control of the pressure of a gas expelled from the opening tends to be difficult.

### Summary of the Invention

### Problems to be Solved by the Invention

An object of the present invention is to provide a method for analysis of a substrate using a nozzle with a simple structure, which enables analysis to be reliably performed without leaking an analysis liquid from the nozzle in scanning of a substrate with the analysis liquid even when the substrate has high hydrophilicity.

### Means for Solving the Problems

For achieving the above-mentioned object, the present invention provides a method for analysis of a substrate using a nozzle as defined in claim 1.

In the nozzle used in the method for analysis of a substrate according to the present invention, the exhaust path between the nozzle main body and the outer pipe is decompressed for holding the analysis liquid present at the tip of the nozzle main body, and by spraying an inert gas to the tip of the nozzle main body in a direction substantially parallel to the substrate surface by the gas spraying pipe disposed on the outer periphery of the tip of the outer pipe and on a side opposite to a scanning direction of the nozzle, the analysis liquid apt to leak from the outer pipe of the nozzle is forced back into the nozzle, and even during scanning of the substrate, leakage of the analysis liquid from the nozzle can be more reliably prevented. The nozzle used in the method for analysis of a substrate according to the present invention has a structure in which the exhaust path between the nozzle main body and the outer pipe can be decompressed, so that the present invention can be implemented with such an extremely simple structure that a gas spraying pipe is disposed on the outer periphery of the tip of the outer pipe and on a side opposite to a scanning direction of the nozzle. In the nozzle used in the method for analysis of a substrate according to the present invention, leakage of the analysis liquid can be effectively prevented merely by adjusting the spraying amount of an inert gas sprayed from the gas spraying pipe, and therefore a mechanism for strictly controlling pressure adjustment in decompression of the exhaust path between the nozzle main body and the outer pipe, or the like is not required. As the inert gas to be used for spraying, a nitrogen gas, an argon gas or the like can be used.

The shape of the gas spraying pipe is not particularly limited, and the spraying angle of the inert gas from the gas spraying pipe is in a range of 0 degree to 75 degrees with respect to the substrate surface. When the inert gas is sprayed perpendicularly to the substrate surface, the inert gas collided against the substrate flows and spreads in a direction substantially parallel to the substrate surface, and for ensuring that the inert gas sprayed to the substrate surface actively flows toward the tip of the nozzle main body, the inert gas is sprayed at a spraying angle of 0 degree to 75 degrees with respect to the substrate surface, i.e. the inert gas is sprayed in a direction parallel to the substrate surface, or the inert gas is sprayed in a direction inclined with respect to the direction perpendicular to the substrate surface, so that leakage of the analysis liquid can be effectively prevented. Even when the spraying angle exceeds 75 degrees, the effect of spraying inert gas is not significantly changed, and the spraying amount of the inert gas tends to increase. The spraying angle is more preferably 0 degree to 30 degrees.

The method for analysis of a substrate using a nozzle according to the present invention is particularly suitable for analysis of a substrate having high hydrophilicity. Examples of the substrate having high hydrophilicity include semiconductor substrates obtained by bulk-etching so called a P+ or P++ silicon wafer having a relatively high boron content, silicon wafers injected with ions with high energy, silicon wafers after decomposition of an organic substance on a silicon wafer by dry etching, and SiC or glass wafers.

### Advantageous Effects of the Invention

As described above, the present invention provides a method for analysis of a substrate using a nozzle wherein the nozzle includes a double pipe including a nozzle main body adapted to discharge and suction an analysis liquid, and an outer pipe disposed on the outer periphery of the nozzle main body so as to surround the analysis liquid when held at a tip of the nozzle main body, an exhaust means having an exhaust path between the nozzle main body and the outer pipe, and the nozzle has such an extremely simple structure that a gas spraying pipe for spraying an inert gas to a tip of the nozzle main body is disposed on the outer periphery of the tip of the outer pipe and on a side opposite to a scanning direction of the nozzle. Thus, falling of the analysis liquid during scanning can be reliably prevented, and even a substrate surface having high hydrophilicity can be efficiently analyzed without falling of the analysis liquid.

### Brief Description of the Drawings

Fig. 1 depicts a sectional view of a conventional double-pipe nozzle for analysis of a substrate.
Fig. 2 depicts a sectional view of a nozzle used in the method for analysis of a substrate in an embodiment.
Fig. 3A depicts a schematic view of a longitudinal cross-section of a nozzle tip in the embodiment.
Fig. 3B depicts a schematic view of a lateral cross-section of the nozzle tip in the embodiment.

### Description of Embodiment

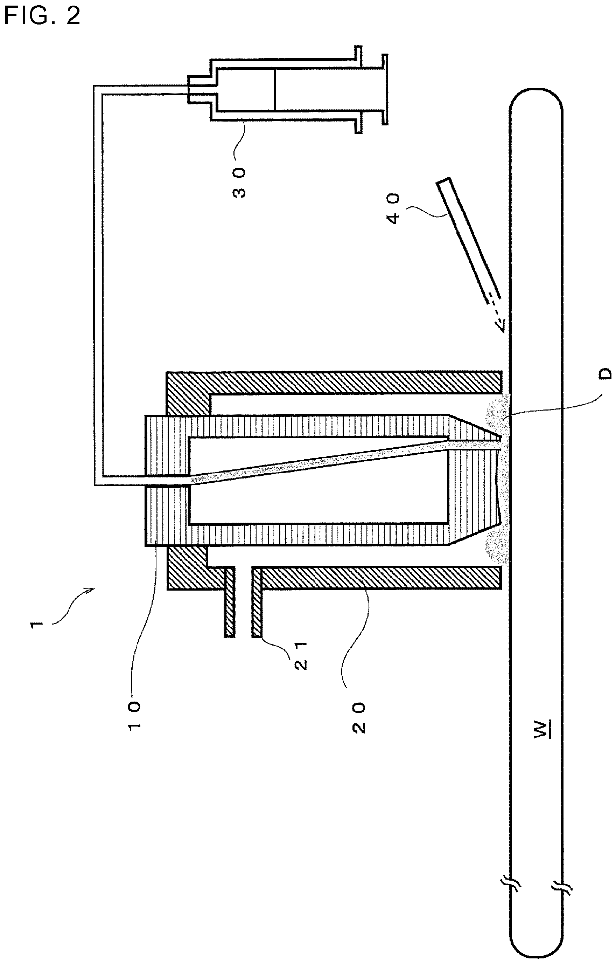

Hereinafter, an embodiment of the present invention will be described. Fig. 2 shows a sectional view of a nozzle used in the method for analysis of a substrate according to the present invention. A nozzle 1 in Fig. 2 includes a double pipe including a nozzle main body 10 and an outer pipe 20. The nozzle main body 10 is connected to a syringe pump 30 via a tube, so that an analysis liquid D can be discharged to the tip side. The outer pipe 20 is provided with suction means 21 connected to a pump (not illustrated) so that a space between the nozzle main body 10 and the outer pipe 20 is brought into a reduced-pressure atmosphere.

Further, in the nozzle 1 in this embodiment, a gas spraying pipe 40 for spraying an inert gas is disposed on the outer periphery of the tip of the outer pipe 20. The gas spraying pipe 40 is disposed at a position corresponding to a side opposite to the scanning direction (moving direction) of the nozzle 1. The nozzle scanning operation can be performed for the whole surface of a substrate W by, for example, a method in which the nozzle is moved from the inside to the outside while the substrate (wafer W) is rotated.

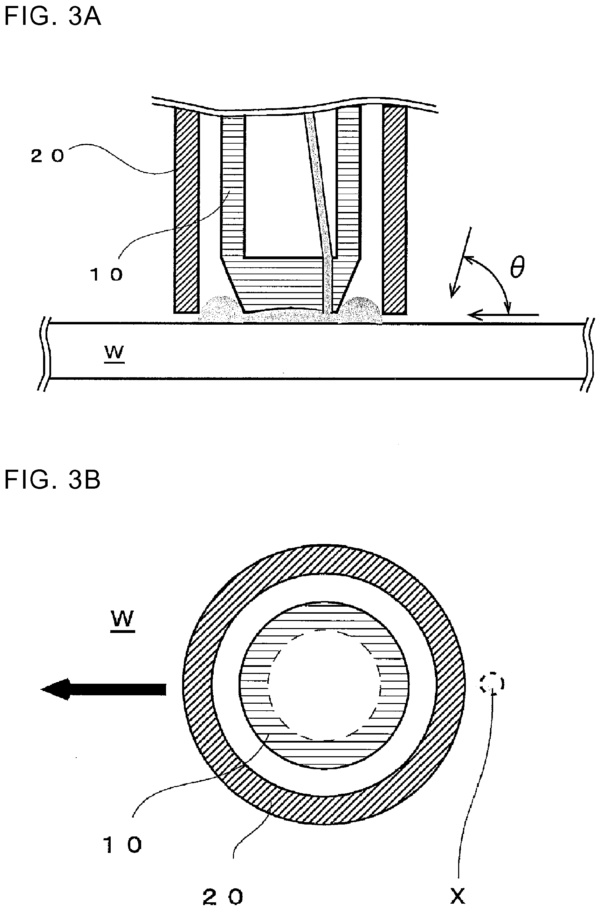

The gas spraying pipe 40 is in the form of a pipe, and may be disposed substantially parallel to the substrate surface, or disposed in an inclined state with respect to the substrate surface in such a manner that the inert gas flows toward the tip of the nozzle main body on the outer periphery of the tip of the outer pipe 20. Specifically, as shown in Fig. 3A, the gas spraying pipe 40 is disposed in such a manner that the inert gas is sprayed at a spraying angle θ of 0 degree to 75 degrees.

For example, when the spraying angle is 30 degrees, a location X allowing the inert gas to be sprayed in a direction substantially parallel to the substrate surface in such a manner that the inert gas moves to the tip of the nozzle main body 10 as shown in Fig. 3B is selected as a position at which the inert gas is sprayed by the gas spraying pipe 40. The spraying position can be determined with consideration given to the pipe cross-sectional area of the gas spraying pipe 40, the spraying amount and the like. For the flow rate of the inert gas to be sprayed, the pipe diameter and the gas flow rate is adjusted so that the linear velocity of the inert gas expelled from the gas spraying pipe 40 is 10 to 30 m/sec. Specifically, the pipe diameter of the gas spraying pipe 40 is set to 0.5 to 3.0 mm.

Analysis using the nozzle for analysis of a substrate in this embodiment will be described. In the nozzle in this embodiment, a nozzle is used in which the size of the nozzle main body is 10 mm, the outer pipe is 20 mm, and thus the ratio of the size of the outer pipe to the size of the nozzle main body is 2 in terms of a diameter (the same applies to nozzles in Comparative Examples 1 and 2 as described below). The gas spraying pipe 40 has a pipe inner diameter of 2.0 mm, and the inert gas is sprayed to a location (spraying position X) at a distance of 50 mm from the outer peripheral end of the outer pipe 20 shown in Fig. 3B so that the spraying angle is 30 degrees.

Specific analysis methods and results of carrying out the analysis methods will now be described. As analysis methods, a method of Comparative Example 1, a method of Comparative Example 2 and a method of Example 1 were sequentially carried out, and the scan speed of the nozzle and leakage of the analysis liquid were examined. Here, a conventional nozzle for analysis of a substrate as shown in Fig. 1 was used, and suction means 21 was not used in Comparative Example 1, the conventional nozzle for analysis of a substrate was used, and suction means 21 was used in Comparative Example 2, and a nozzle for analysis of a substrate which includes a gas spraying pipe as shown in Fig. 2 was used in Example 1. As a substrate to be analyzed, a semiconductor substrate including a 203 mm (8-inch) silicon wafer containing boron in an amount of 5 × 10¹⁹ atoms/cm³.

<Comparative Example 1> First, the provided semiconductor substrate was subjected to etching by a vapor phase decomposition method using an ozone gas and hydrofluoric acid vapor. Thereafter, a surface of the semiconductor substrate was scanned at a rate of 1 mm/sec by use of the nozzle in Fig. 1 to carry out analysis.

As an analysis procedure, first the nozzle was immersed in an analysis liquid containing 3% HF and 4% H₂O₂, and the analysis liquid was suctioned with the syringe pump 30 to fill a liquid reservoir of the nozzle main body 10 with 1000 µL of the analysis liquid. Thereafter, 800 µL of the analysis liquid D was discharged onto the semiconductor substrate W, and an scanning operation of the nozzle was performed in such a manner that the analysis liquid D passed over the whole surface of the substrate W while the analysis liquid D was held at the tip of the outer pipe 20 so as to surround the analysis liquid D. In Comparative Example 1, spraying means 21 was not used. As a result, in Comparative Example 1, the analysis liquid was leaked from the nozzle tip even when the scan speed of the nozzle (relative speed of the wafer and the nozzle) was 1 mm/sec.

<Comparative Example 2> In Comparative Example 2, the same conditions as in Comparative Example 1 were employed, and during the nozzle scanning operation, a space between the nozzle main body 10 and the outer pipe 20 was brought into a pressure-reduced atmosphere by suction means 21 at a suction rate of 0.3 to 1.0 L/min by use of a pump. As a result, in Comparative Example 2, a phenomenon in which the analysis liquid is leaked from the nozzle tip did not occur when the scan speed of the nozzle was 2 mm/sec. However, the analysis liquid was leaked when the scan speed of the nozzle was 3 mm/sec.

<Example 1 > In Example 1, analysis was performed by use of a nozzle for analysis of a substrate which includes a gas spraying pipe as shown in Fig. 2. As an inert gas, a nitrogen gas was used, and the spraying amount was set to 2.0 L/min. A space between the nozzle main body 10 and the outer pipe 20 was brought into a pressure-reduced atmosphere with suction means 21 under the same conditions as in Comparative example 2. As a result, in Example 1, a phenomenon in which the analysis liquid is leaked from the nozzle tip did not occur even when the scan speed of the nozzle was 10 mm/sec. The whole surface of the substrate was subjected to a scanning operation by the nozzle without causing the analysis liquid to remain on the substrate surface during the nozzle scanning operation.

The results of the analyses described above showed that merely by spraying the inert gas to the outer periphery of the outer pipe with the gas spraying pipe, a scanning operation of the nozzle was performed at a rate higher by a factor of 5 as compared to the case where only the suction means of the nozzle was used (Comparative Example 2). Further, it was found that in a wafer having high hydrophilicity, it was not necessarily able to hold the analysis liquid at the nozzle tip during scanning merely by decompression with the suction means of the nozzle even when the scan speed was reduced, but when the gas spraying pipe was used, it was able to reliably hold the analysis liquid at the nozzle tip as long as the scan speed was reduced, so that a phenomenon in which the analysis liquid is leaked from the nozzle tip was effectively prevented.

### Industrial Applicability

In the present invention, even a substrate having high hydrophilicity can be analyzed while a phenomenon in which an analysis liquid is leaked from the tip of a nozzle is reliably prevented, and therefore a very small amount of contaminants such as, for example, metal contained in the substrate can be efficiently analyzed. In addition, the nozzle has an extremely simple structure, and a mechanism for adjustment of a gas spraying pressure, etc. is unnecessary, resulting in improvement economic efficiency in terms of an apparatus cost.

### Reference Signs List

- 10: Nozzle main body
- 20: Outer pipe
- 21: Suction means
- 30: Syringe pump
- 40: Gas spraying pipe
- W: Wafer (substrate)
- D: Analysis liquid

## Claims

1. Method for analysis of a substrate (W) using a nozzle (1) comprising a double pipe including a nozzle main body (10) adapted to discharge and suction an analysis liquid (D) and an outer pipe (20) disposed on an outer periphery of the nozzle main body (10) so as to surround the analysis liquid (D) when held at a tip of the nozzle main body (10), an exhaust means (21) having an exhaust path between the nozzle main body (10) and the outer pipe (20), and a gas spraying pipe (40) for spraying an inert gas to the tip of the nozzle main body (10) being disposed on the outer periphery of a tip of the outer pipe (20) and on a side opposite to a scanning direction of the nozzle (1), wherein the method comprises the steps:
discharging the analysis liquid (D) onto the substrate (W) from the tip of the nozzle main body (10),
decompressing the exhaust path between the nozzle main body (10) and the outer pipe (20) for holding the analysis liquid (D) present at the tip of the nozzle main body (10);
spraying an inert gas to the tip of the nozzle main body (10) by the gas spraying pipe (40) disposed on the outer periphery of the tip of the outer pipe (20) and on a side opposite to a scanning direction of the nozzle (10), wherein the spraying angle of the inert gas from the gas spraying pipe (40) is in a range of 0 degree to 75 degrees with respect to a surface of the substrate (W),
scanning the whole surface of the substrate (W) with the discharged analysis liquid (D) being held,
suctioning the analysis liquid (D) after scanning the whole surface of the substrate (W) with the discharged analysis liquid (D) being held, and
analyzing the analysis liquid (D).

## Patentansprüche

1. Verfahren zur Analyse eines Substrats (W) unter Verwendung einer Düse (1), die ein Doppelrohr aufweist, umfassend einen Düsenhauptkörper (10), welcher dazu ausgebildet ist, eine Analyseflüssigkeit (D) abzugeben und anzusaugen, und ein äußeres Rohr (20), welches an einem Außenumfang des Düsenhauptkörpers (10) angeordnet ist, um die Analyseflüssigkeit (D) zu umgeben, wenn es an einer Spitze des Düsenhauptkörpers (10) gehalten wird, ein Auslassmittel (21) mit einem Auslasspfad zwischen dem Düsenhauptkörper (10) und dem äußeren Rohr (20), und ein Gassprührohr (40) zum Sprühen eines Inertgases auf die Spitze des Düsenhauptkörpers (10), das am Außenumfang einer Spitze des äußeren Rohrs (20) und auf einer Seite entgegengesetzt zu einer Abtastrichtung der Düse (1) angeordnet ist, wobei das Verfahren die folgenden Schritte umfasst:
Abgeben der Analyseflüssigkeit (D) auf das Substrat (W) von der Spitze des Düsenhauptkörpers (10),
Dekomprimieren des Auslassweges zwischen dem Düsenhauptkörper (10) und dem äußeren Rohr (20) zum Halten der an der Spitze des Düsenhauptkörpers (10) vorhandenen Analyseflüssigkeit (D);
Sprühen eines Inertgases auf die Spitze des Düsenhauptkörpers (10) durch das Gassprührohr (40), das am Außenumfang der Spitze des äußeren Rohrs (20) und auf einer Seite entgegengesetzt zu einer Abtastrichtung der Düse (10) angeordnet ist, wobei der Sprühwinkel des Inertgases aus dem Gassprührohr (40) in einem Bereich von 0 Grad bis 75 Grad in Bezug auf eine Oberfläche des Substrats (W) liegt,
Abtasten der gesamten Oberfläche des Substrats (W), wobei die abgegebene Analyseflüssigkeit (D) gehalten wird,
Ansaugen der Analyseflüssigkeit (D) nach dem Abtasten der gesamten Oberfläche des Substrats (W), wobei die abgegebene Analyseflüssigkeit (D) gehalten wird, und Analysieren der Analyseflüssigkeit (D).

## Revendications

1. Procédé d'analyse d'un substrat (W) utilisant une buse (1) comprenant un double tuyau comprenant un corps principal de buse (10) adapté pour décharger et aspirer un liquide d'analyse (D) et un tuyau extérieur (20) disposé sur une périphérie extérieure du corps principal de buse (10) de façon à entourer le liquide d'analyse (D) lorsqu'il est maintenu à une pointe du corps principal de buse (10), un moyen d'échappement (21) ayant un chemin d'échappement entre le corps principal de buse (10) et le tuyau extérieur (20), et un tuyau de pulvérisation de gaz (40) pour pulvériser un gaz inerte sur la pointe du corps principal de buse (10) étant disposé sur la périphérie extérieure d'une pointe du tuyau extérieur (20) et sur un côté opposé à une direction de balayage de la buse (1), dans lequel le procédé comprend les étapes suivantes :
décharger le liquide d'analyse (D) sur le substrat (W) à partir de la pointe du corps principal de buse (10),
décompresser le chemin d'échappement entre le corps principal de buse (10) et le tuyau extérieur (20) pour maintenir le liquide d'analyse (D) présent à la pointe du corps principal de buse (10) ;
pulvériser un gaz inerte sur la pointe du corps principal de buse (10) par le tuyau de pulvérisation de gaz (40) disposé sur la périphérie extérieure de la pointe du tuyau extérieur (20) et sur un côté opposé à une direction de balayage de la buse (10), dans lequel l'angle de pulvérisation du gaz inerte provenant du tuyau de pulvérisation de gaz (40) est dans une plage de 0 degré à 75 degrés par rapport à une surface du substrat (W),
balayer la surface entière du substrat (W) avec le liquide d'analyse déchargé (D) étant maintenu,
aspirer le liquide d'analyse (D) après avoir balayé la surface entière du substrat (W) avec le liquide d'analyse déchargé (D) étant maintenu, et analyser le liquide d'analyse (D).
